# EUROPEAN PATENT SPECIFICATION

(11) **EP 3 719 999 B1**
(45) Date of publication and mention of the grant of the patent: **22.11.2023**
(21) Application number: 19166932.4
(22) Date of filing: 03.04.2019
(51) Int. Cl.: H03K 17/689, H05B 45/3725

(54) **PROTECTED LED DRIVER CIRCUIT**
GESCHÜTZTE LED-TREIBERSCHALTUNG
CIRCUIT DE COMMANDE À DEL PROTÉGÉ

(43) Date of publication of application: 07.10.2020
(73) Proprietor: Tridonic GmbH & Co. KG, 6851 Dornbirn (AT)
(72) Inventor: Santiago, Alekssander, Spennymoor, DL166FL (GB); Klotz, Reimar, 6850 Dornbirn (AT); Maldoner, Jakob, 6655 Steeg (AT)
(74) Representative: Rupp, Christian

(56) References cited:
- EP-A1- 2 387 154
- WO-A1-2016/014270
- US-A1- 2007 035 481
- US-A1- 2013 320 875
- Stone Holy: "SCC Series -Safety Capacitors", , 29 November 2018 (2018-11-29), pages 19-20, XP055623314, Retrieved from the Internet: URL:https://www.holystoneeurope.com/pdf/SC C.pdf [retrieved on 2019-09-18]

## Description

### TECHNICAL FIELD

The present invention relates to the field of lighting devices and to light emitting diode (LED) driver circuits, wherein a switch or a secondary side of an LED driver circuit is protected, e.g. in case of failure in the driver circuit. In particular, the LED driver circuit is operated in a cycled manner, e.g. by a Boolean signal output by a control circuit of the driver circuit.

### BACKGROUND

In the prior art, an LED driver circuit is protected by means of an safety extra-low voltage (SELV) barrier that isolates a primary side of the LED driver circuit from a secondary side of the LED driver circuit. In other words, the primary side is galvanically separated from the secondary side.

A common way to control a semiconductor switch of an LED driver circuit over a galvanically separated barrier is to use a transformer or optocouplers. The negative aspect of the transformers are the relatively high prices, the size and the fact that they often have to be mounted one the PCB manually. Optocouplers on the other hand are cheaper, can be smaller in size than inductances but show negative aspects like aging effects that include influence of gain, strong temperature influences or smooth asymmetric turn on off edges which can be critical at higher frequencies. Also, such solutions are very expensive, in particular when an SELV barrier is to be bridged.

Further, LED driver circuits have to be protected against component failures, especially when they are used for emergency products. In the event of a component failure, the LED driver circuit is desired to fail safely, not catching fire neither getting extremely hot, above a triangle temperature. Failure of switches of the LED driver circuit (e.g. switching MOSFETs) that are normally connected to a power rail are one of the worst case scenarios for component failure, not only due to its own failure, but also a failure of a control circuit controlling the switch (e.g. a control unit, a controller IC or microcontroller or a gate driving circuit component). If one of these fails, the power rail will be short-circuited, releasing all available energy. This may cause the overheat of the switch (e.g. the MOSFET) itself, the inductor or any other component in line with a main power circuit. Consequently, the LED driver circuit might easily reach the triangle temperature and fail a safety standard requirement.

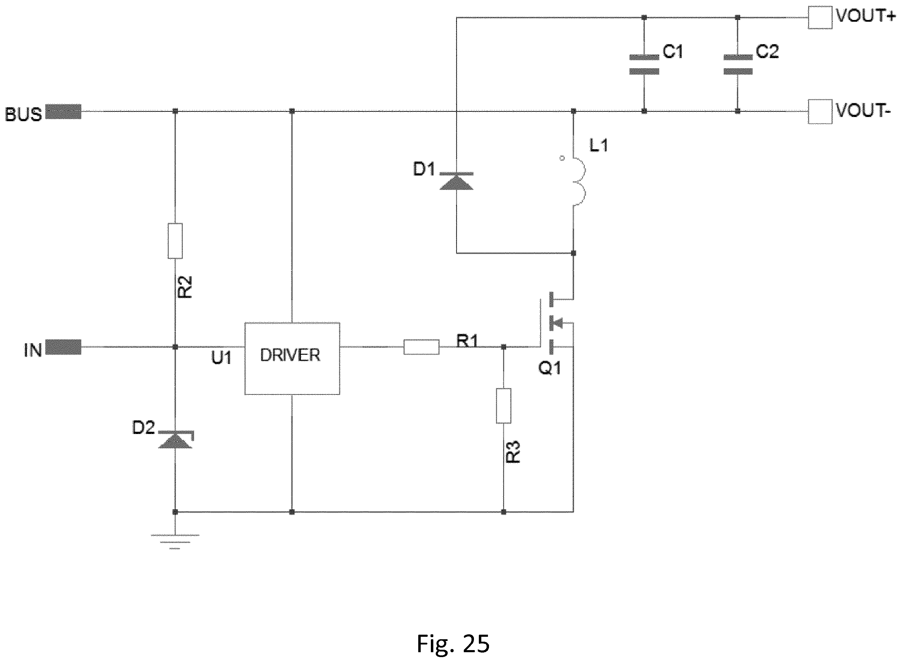

The problem can be better understood with a practical example. FIG. 25 shows an LED driver circuit according to the prior art. As shown in FIG. 25, a BUS voltage is supplied by a secondary side of a flyback converter. IN input is connected to a microcontroller. U1 is an inverting driver (i.e. a control circuit) and for this reason R2 and D2 exist. R2 is a pull-up to maintain the driver off while the microcontroller's not fully operating and D2 is a Zener diode to prevent the microcontroller pin to be subjected to higher voltage than what it can withstand. During a triangle temperature assessment, D2 is shorted to ground, forcing the U1 output to be logic high. U1 supplies the MOSFET gate with the BUS voltage. This failure simulation is representative for D2 failure, Microcontroller failure or driver U1 failure.

As result, the switch Q1 is constantly on, dissipating all of the energy the flyback could supply, forcing the flyback to operate in overload condition.

It can be argued that the flyback IC could detect the short-circuit in the BUS and turn itself off, as most ICs available in the market do. However, because the gate is supplied by the BUS through U and as the BUS voltage starts to drop, also the voltage at the gate starts to drop and consequently the MOSFET starts to turn off. As the MOSFET starts to open, the bus rises again and the whole cycle repeats. In the end, the system self-balances, the BUS voltage stabilizes around 2V (near the MOSFET gate threshold voltage) and the flyback keeps delivering the maximum amount of power it can without detecting the failure.

That is, in the prior art there is a need to protect LED driver circuits, in particular a switch of the LED driver circuit that is controlled by a control circuit of the LED driver circuit. It is in particular desired that such a protection can be manufactured cheaply and can be used with a variety of different lighting devices or lighting circuits.

Document EP 2387154 A1 discloses a capacitive bridge circuit consisting of four capacitors arranged in the form of an H-bridge, which is used for galvanic separation of two circuits working at different reference potentials, between which electrical impulses are transmitted.

Document WO 2016/014270 A1 discloses that a field-effect transistor (FET) driver is provided that includes an input modulator and an isolating capacitor. The input modulator is configured to output an alternating current (AC) signal. The isolating capacitor is configured to receive the AC signal as an input and to store a charge based on the AC signal in a filter capacitor. The filter capacitor is configured to drive a capacitor-driven FET based on the stored charge.

Document US 2007/035481 A1 a flat display device which may include a plurality of electrodes arranged in one direction, a first transistor coupled between the plurality of electrodes and a first power source for supplying a first voltage, and a gate driving circuit for supplying a driving voltage to a gate of the first transistor through a push-pull circuit including second and third transistors coupled between second and third power sources for respectively supplying second and third power sources, wherein a resistance formed between the second transistor and the second power source is greater than that formed between the third transistor and the third power source.

### SUMMARY

In view of the above-mentioned drawbacks, the present invention aims to improve the conventional protection means for LED driver circuits.

Therefore, it is an object of the present invention to provide an LED driver circuit in which a switch is protected by means of at least one capacitive element, in particular protected from a failure in a control circuit.

These and other objects, which become apparent upon reading the following description, are solved by the subject-matter of the independent claims. The dependent claims refer to preferred embodiments of the invention.

A first aspect of the present invention provides an electrically isolated LED driver circuit, comprising a control circuit at a primary side of the LED driver circuit, a switch at a secondary side of the LED driver circuit, a semiconductor element and at least one capacitive element; wherein the control circuit is configured to control the switch in a cycled manner; wherein the at least one capacitive element is configured to couple the primary side and the secondary side in an electrically isolated manner; wherein the semiconductor element is in particular configured to enable discharging of the at least one capacitive element; wherein the control circuit is configured to output a control signal to control the switch, and wherein the LED driver circuit further comprises an amplifying circuit on the secondary side configured to amplify the control signal.

In particular, the semiconductor element is configured to enable fast discharging of the at least one capacitive element
This is beneficial as it provides a safe and very cheap way to control semiconductor switches or logic over a galvanically separated barrier. Also, all components can be mounted simply by machine. Further, this concept offers different variations to fit various situations. Tis principle can also be used for communication purposes, and it can potentially improve the electromagnetic interference behavior.

The control circuit which controls the switch allows for different devices to be controlled over the circuit (with a Boolean input). For example, a UART communication or GPIO control can be realized with this concept.

In particular, the switch is a semiconductor switch. In particular, the switch is a transistor or a MOSFET transistor. In particular, the switch is configured so that a Boolean input signal can be applied to it.

In an implementation form of the first aspect, the at least one capacitive element is a capacitor.

In another implementation form of the first aspect, the at least one capacitive element is a Y-capacitor, preferably a Y1-capacitor or a Y2-capacitor.

In particular, the Y-capacitor is configured to allow for a retransfer of a signal from the secondary side to the primary side.

In another implementation form of the first aspect, the at least one capacitive element includes a first capacitive element and a second capacitive element, wherein the first capacitive element and the second capacitive element are configured to couple the primary-side and the secondary-side in an electrically isolated manner.

In particular, the first capacitive element is a capacitor. In particular, the first capacitive element is a Y-capacitor, preferably a Y1-capacitor or a Y2-capacitor.

In particular, the second capacitive element is a capacitor. In particular, the second capacitive element is a Y-capacitor, preferably a Y1-capacitor or a Y2-capacitor.

In particular, a first port of the first capacitive element is connected to a first output of the control circuit.

In particular, a first port of the second capacitive element is connected to a second output of the control circuit.

In particular, a second port of the first capacitive element is connected to a first input of the switch.

In particular, a second port of the second capacitive element is connected to a second input of the switch.

In another implementation form of the first aspect, the first capacitive element is arranged in a first path of the LED driver circuit, and the second capacitive element is arranged in a second path of the LED driver circuit.

In particular, the first path is represented by the first output of the control circuit, the first port of the first capacitive element, the second port of the first capacitive element, and the first input of the switch.

In particular, the second path is represented by the second output of the control circuit, the first port of the second capacitive element, the second port of the second capacitive element, and the second input of the switch.

In another implementation form of the first aspect, the LED driver circuit further comprises a third capacitive element, configured to couple the first path and the second path.

In particular, a first port of the third capacitive element is connected to the second port of the first capacitive element. In particular, a second port of the third capacitive element is connected to the second port of the second capacitive element.

In particular, the third capacitive element is a dedicated capacitive element.

In particular, the third capacitive element is a capacitor.

In particular, the third capacitive element is implemented by means of an intrinsic or parasitic capacity of a semiconductor element.

In particular, the third capacitive element is implemented by means of a gate-source-capacity of a switching transistor.

In another implementation form of the first aspect, the semiconductor element is connected to the first path, and to the second path.

In particular, a first port of the semiconductor element is connected to the second port of the first capacitive element. In particular, a second port of the semiconductor element is connected to the second port of the second capacitive element.

In particular, the semiconductor element is a diode.

In particular, the semiconductor element can be any kind of semiconductor component, e.g. a mosfet, triac, or BJT.

In particular, the diode blocks a voltage from its first port in the direction of its second port.

In particular, the diode enables (fast) discharging of the capacitive elements (e.g. the capacitors) and prevents with that an unwanted voltage shift on the third capacitive element (C3, 203). Without the diode, an undefined offset shift emerges, which is dependent on the duty cycle.

In another implementation form of the first aspect, the semiconductor element is configured to control a voltage through the third capacitive element.

In the implementation form of the first aspect, the control circuit is configured to output a control signal to control the switch, and wherein the LED driver circuit further comprises an amplifying circuit arranged at the secondary side configured to amplify the control signal.

In particular, the amplifying circuit includes an amplifying network.

In another implementation form of the first aspect, the control circuit is configured to control the switch by means of a Boolean signal.

A second aspect not covered by the present invention provides an LED driver circuit, comprising a control circuit, a switch, and a capacitive element; wherein the control circuit is configured to control the switch in a cycled manner; and wherein the capacitive element is configured to decouple an output of the control circuit from an input of the switch.

This solution is beneficial because of the simplicity and effectiveness of the circuit. It has no gain or attenuation in normal conditions. It is 100% effective and does not rely on any measurement, sensing or control action, therefore being independent. As it only uses passive components, it is very cheap, e.g. cheaper than any active solution. The circuit is tunable to obtain best performance for each switching frequency. The main advantage is the fail safe mode added to the Led driver circuit, with minimal cost, and no technical disadvantage. Therefore, there is no need for active protection or high powered MOSFET transistors, designed to withstand short-circuits, using very cheap components. Thus, the product is cheaper. Further advantages of the LED driver circuit are: It is effective for the purpose it is intended for. It reacts only to the nature of the input signal and can be tuned for ideal performance. It is not dependent on measurement or active components. It is cheap to implement (small MLCC, a small signal diode and a SMD resistor). It requires minimal additional components. It has minimal or no impact in normal operation. It is not voltage dependent or power level dependent, so it can be applied in any switching N-channel gate. It is not dependent on a controller, so it works with of the shelf ICs or microcontrollers.

In particular, the capacitive element is a capacitor.

In particular, the switch is a semiconductor switch, e.g. a transistor, or a MOSFET transistor. In particular, the switch is configured so that a Boolean input signal can be applied to it.

In particular, the capacitive element comprises a first port and a second port, wherein the first port is connected to the control circuit, and wherein the second port is, directly or indirectly, connected to the switch.

In particular, in case of a failure of the control circuit, the switch is not permanently applied with deci-voltage and thus not permanently turned on (which could lead to a short circuit between a bus voltage and a ground potential and in turn could damage the switch itself or other elements).

In particular, the capacitive element is configured to decouple the output of the control circuit from the control input of the switch, so that no deci-voltage is present in case of a failure of the control circuit and thus the switch does not remain permanently switched on.

In an implementation form of the second aspect, the LED driver circuit further comprises a resistor connected to the capacitive element and to a ground potential.

In particular, a first port of the resistor is connected to the second port of the capacitive element, and a second port if the resistor is connected to the ground potential.

In particular, by means of the resistor, the potential at the input of the switch is pulled to ground in case of a failure of the control circuit.

In particular, the resistor is provided as a pull-down resistor, so that in the event of a failure of the control circuit, a potential at the input of the switch does not remain, but rather is pulled to a ground potential.

In another implementation form of the second aspect, the LED driver circuit further comprises a semiconductor element connected to the capacitive element and to a ground potential.

In particular, the semiconductor element is a diode.

In particular, the diode blocks a voltage from its first port in the direction of its second port.

In another implementation form of the second aspect, the LED driver circuit further comprises a second resistor connected to the capacitive element and to the switch, thereby indirectly connecting the capacitive element to the switch.

In particular, a first port of the second resistor is connected to the second port of the capacitive element, and a second port of the second resistor is connected to an input of the switch.

In another implementation form of the second aspect, the control circuit is configured to control the switch by means of a Boolean signal.

A third aspect of the present invention provides a method for operating an electrically isolated LED driver circuit, wherein the LED driver circuit comprises a control circuit at a primary side of the LED driver circuit, a switch at a secondary side of the LED driver circuit, a semiconductor element, and at least one capacitive element; the method comprising the steps of: controlling, by the control circuit, the switch in a cycled manner; coupling, by the at least one capacitive element, the primary side and the secondary side in an electrically isolated manner; and in particular enabling, by the semiconductor element, discharging of the at least one capacitive element, wherein the control circuit is configured to output a control signal to control the switch, and wherein the LED driver circuit further comprises an amplifying circuit on the secondary side configured to amplify the control signal.

In particular, the semiconductor element enables fast discharging of the at least one capacitive element.

In particular, the switch is a semiconductor switch, e.g. a transistor, or a MOSFET transistor. In particular, the switch is configured so that a Boolean input signal can be applied to it.

In an implementation form of the third aspect, the at least one capacitive element is a capacitor.

In another implementation form of the third aspect, the at least one capacitive element is a Y-capacitor, preferably a Y1-capacitor or a Y2-capacitor.

In particular, the Y-capacitor allows for a retransfer of a signal from the secondary side to the primary side.

In another implementation form of the third aspect, the at least one capacitive element includes a first capacitive element and a second capacitive element, wherein the first capacitive element and the second capacitive element couple the primary-side and the secondary-side in an electrically isolated manner.

In particular, the first capacitive element is a capacitor. In particular, the first capacitive element is a Y-capacitor, preferably a Y1-capacitor or a Y2-capacitor.

In particular, the second capacitive element is a capacitor. In particular, the second capacitive element is a Y-capacitor, preferably a Y1-capacitor or a Y2-capacitor.

In particular, a first port of the first capacitive element is connected to a first output of the control circuit.

In particular, a first port of the second capacitive element is connected to a second output of the control circuit.

In particular, a second port of the first capacitive element is connected to a first input of the switch.

In particular, a second port of the second capacitive element is connected to a second input of the switch.

In another implementation form of the third aspect, the first capacitive element is arranged in a first path of the LED driver circuit, and the second capacitive element is arranged in a second path of the LED driver circuit.

In particular, the first path is represented by the first output of the control circuit, the first port of the first capacitive element, the second port of the first capacitive element, and the first input of the switch.

In particular, the second path is represented by the second output of the control circuit, the first port of the second capacitive element, the second port of the second capacitive element, and the second input of the switch.

In another implementation form of the third aspect, the LED driver circuit further comprises a third capacitive element which couples the first path and the second path.

In particular, a first port of the third capacitive element is connected to the second port of the first capacitive element. In particular, a second port of the third capacitive element is connected to the second port of the second capacitive element.

In particular, the third capacitive element is a dedicated capacitive element.

In particular, the third capacitive element is a capacitor.

In particular, the third capacitive element is implemented by means of an intrinsic or parasitic capacity of a semiconductor element.

In particular, the third capacitive element is implemented by means of a gate-source-capacity of a switching transistor.

In another implementation form of the third aspect, the semiconductor element is connected to the first path, and to the second path.

In particular, a first port of the semiconductor element is connected to the second port of the first capacitive element. In particular, a second port of the semiconductor element is connected to the second port of the second capacitive element.

In particular, the semiconductor element is a diode.

In particular, the semiconductor element can be any kind of semiconductor component, e.g. a mosfet, triac, or BJT.

In particular, the diode blocks a voltage from its first port in the direction of its second port.

In particular, the diode enables (fast) discharging of the capacitive elements (e.g. the capacitors) and prevents with that an unwanted voltage shift on the third capacitive element (C3, 203). Without the diode, an undefined offset shift emerges, which is dependent on the duty cycle.

In another implementation form of the third aspect, the semiconductor element controls a voltage through the third capacitive element.

In the implementation form of the third aspect, the control circuit outputs a control signal to control the switch, and the LED driver circuit further comprises an amplifying circuit arranged at the secondary side amplifying the control signal.

In particular, the amplifying circuit includes an amplifying network.

In another implementation form of the third aspect, the control circuit controls the switch by means of a Boolean signal.

The third aspect and its implementation forms provide the same advantages as the first aspect and its implementation forms, respectively.

A fourth aspect not covered by the present invention provides a method for operating an LED driver circuit, wherein the LED driver circuit comprises a control circuit, a switch, and a capacitive element; the method comprising the steps of: controlling, by the control circuit, the switch in a cycled manner; and decoupling, by the capacitive element, an output of the control circuit from an input of the switch.

In particular, the capacitive element is a capacitor.

In particular, the switch is a semiconductor switch, e.g. a transistor, or a MOSFET transistor. In particular, the switch is configured so that a Boolean input signal can be applied to it.

In particular, the capacitive element comprises a first port and a second port, wherein the first port is connected to the control circuit, and wherein the second port is, directly or indirectly, connected to the switch.

In particular, in case of a failure of the control circuit, the switch is not permanently applied with deci-voltage and thus not permanently turned on (which could lead to a short circuit between a bus voltage and a ground potential and in turn could damage the switch itself or other elements).

In particular, the capacitive element decouples the output of the control circuit from the control input of the switch, so that no deci-voltage is present in case of a failure of the control circuit and thus the switch does not remain permanently switched on.

In particular, the control level of high of the output of the control circuit is timewise limited since a static high leads to a discharge of the capacitive element.

In an implementation form of the fourth aspect, the LED driver circuit further comprises a resistor connected to the capacitive element and to a ground potential.

In particular, a first port of the resistor is connected to the second port of the capacitive element, and a second port if the resistor is connected to the ground potential.

In particular, by means of the resistor, the potential at the input of the switch is pulled to ground in case of a failure of the control circuit.

In particular, the resistor is provided as a pull-down resistor, so that in the event of a failure of the control circuit, a potential at the input of the switch does not remain, but rather is pulled to a ground potential.

In another implementation form of the fourth aspect, the LED driver circuit further comprises a semiconductor element connected to the capacitive element and to a ground potential.

In particular, the semiconductor element is a diode.

In another implementation form of the fourth aspect, the LED driver circuit further comprises a second resistor connected to the capacitive element and to the switch, thereby indirectly connecting the capacitive element to the switch.

In particular, a first port of the second resistor is connected to the second port of the capacitive element, and a second port of the second resistor is connected to an input of the switch.

In another implementation form of the fourth aspect, the control circuit controls the switch by means of a Boolean signal.

The fourth aspect and its implementation forms include all advantages of the second aspect and its implementation forms.

### BRIEF DESCRIPTION OF DRAWINGS

In the following, the invention is described exemplarily with reference to the enclosed figures, in which
- FIG. 1: shows a schematic view of an LED driver circuit.
- FIG. 2: shows a schematic view of an LED driver circuit in more detail.
- FIG. 3: shows another schematic view of an LED driver circuit in more detail.
- FIG. 4: shows another schematic view of an LED driver circuit in more detail.
- FIG. 5: shows another schematic view of an LED driver circuit in more detail.
- FIG. 6: shows another schematic view of an LED driver circuit in more detail.
- FIG. 7: shows another schematic view of an LED driver circuit according to an embodiment of the present invention in more detail.
- FIG. 8: shows another schematic view of an LED driver circuit according to an embodiment of the present invention.
- FIG. 9: shows another schematic view of an LED driver circuit according to an embodiment of the present invention in more detail.
- FIG. 10: shows a schematic view of an LED driver circuit according to an embodiment of the present invention.
- FIG. 11: shows another schematic view of an LED driver circuit according to an embodiment not covered by the present invention.
- FIG. 12: shows another schematic view of an LED driver circuit according to an embodiment not covered by the present invention.
- FIG. 13: shows a simulation result of an LED driver circuit according to an embodiment not covered by the present invention.
- FIG. 14: shows a simulation result of an LED driver circuit according to an embodiment not covered by the present invention.
- FIG. 15: shows another schematic view of an LED driver circuit according to an embodiment not covered by the present invention in more detail.
- FIG. 16: shows another schematic view of an LED driver circuit according to an embodiment not covered by the present invention in more detail.
- FIG. 17: shows another schematic view of an LED driver circuit according to an embodiment not covered by the present invention in more detail.
- FIG. 18: shows another schematic view of an LED driver circuit according to an embodiment not covered by the present invention in more detail.
- FIG. 19: shows a simulation result of an LED driver circuit according to an embodiment not covered by the present invention.
- FIG. 20: shows a simulation result of an LED driver circuit according to an embodiment not covered by the present invention.
- FIG. 21: shows a simulation result of an LED driver circuit according to an embodiment not covered by the present invention.
- FIG. 22: shows a simulation result of an LED driver circuit according to an embodiment not covered by the present invention.
- FIG. 23: shows a schematic view of a method according to an embodiment not covered by the present invention.
- FIG. 24: shows a schematic view of a method according to an embodiment not covered by the present invention.
- FIG. 25: shows a schematic view of an LED driver circuit according to the prior art.

### DETAILED DESCRIPTION OF PREFERRED EMBODIMENTS

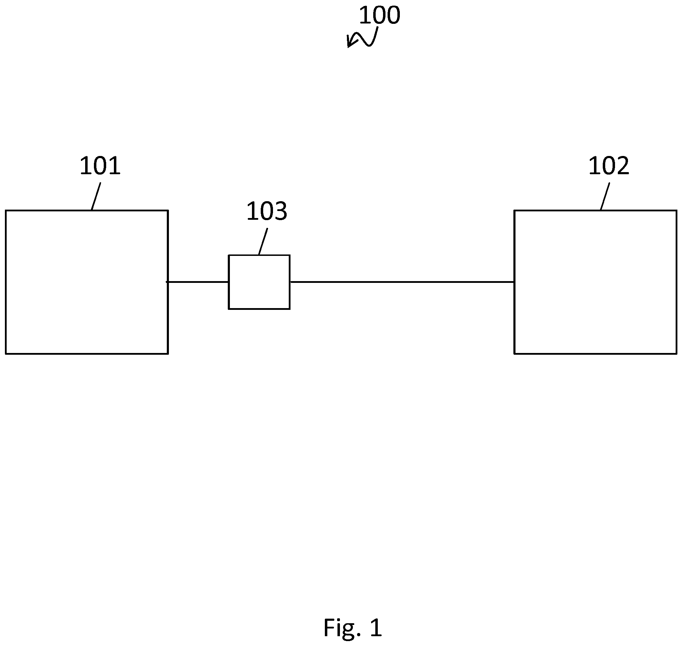

FIG. 1 shows an electrically isolated LED driver circuit.

The LED driver circuit comprises a control circuit 101 at a primary side of the LED driver circuit 100, a switch 102 at a secondary side of the LED driver circuit 100, and at least one capacitive element 103.

The control circuit 101 operates the switch 102 in a cycled manner. That is, the control circuit outputs a pulsed or clocked signal to control the switch 102.

To protect the switch 102, (i.e. to galvanically isolate the secondary side from the first side), the at least one capacitive element 103 couples the primary side and the secondary side in an electrically isolated manner.

That is, the LED driver circuit 100 of FIG. 1 effectively protects the switch 102 in a cheap and efficient manner.

The LED driver circuit 100 can also comprise a semiconductor element which is configured to enable discharging of the at least one capacitive element 103.

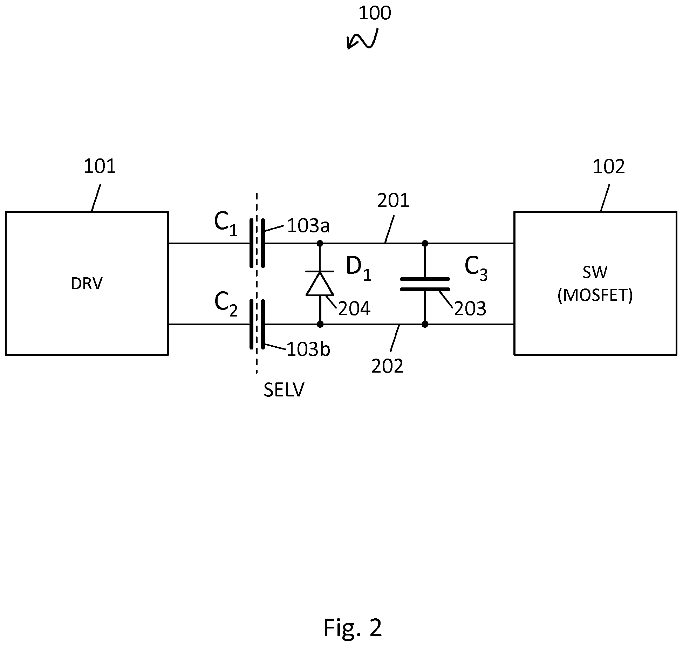

FIG. 2 shows an electrically isolated LED driver circuit 100 in more detail. The LED driver circuit 100 of FIG. 2 includes all functions and features of the LED driver circuit 100 of FIG. 1.

FIG. 2 illustrates the concept of the LED driver circuit 100, which comprises the control circuit 101 (also called driver block (DRV)) that outputs a control signal (idealised high or zero in a cycled manner), a SELF barrier or any other kind of galvanic separation means (dotted line), two capacitors C₁ 103a and C₂ 103b that bridge the barrier, a diode D₁ 204 (that is, the semiconductor element of Fig. 1), a secondary side capacitor C₃ 203 and a switch 102 (also called SW block, or semiconductor switch input) that gets controlled by the voltage over C₃ 203.

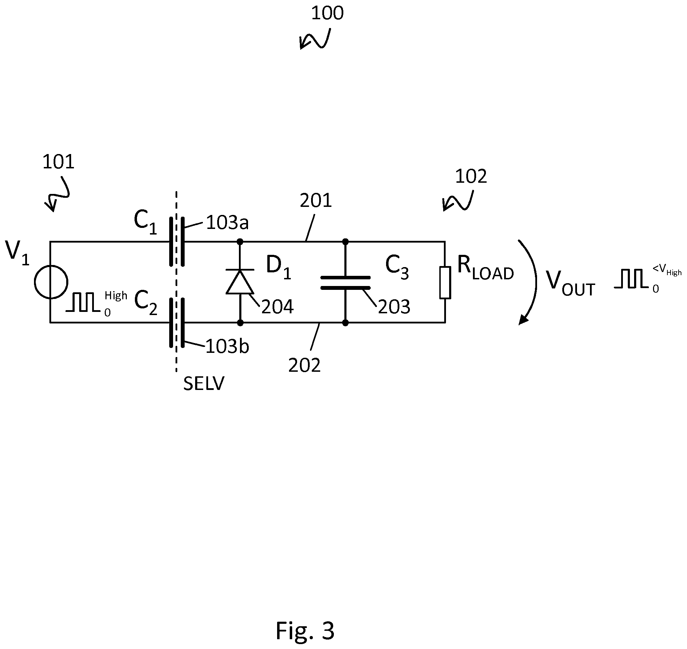

FIG. 3 shows an electrically isolated LED driver circuit 100 in more detail. The LED driver circuit 100 of FIG. 3 includes all functions and features of the LED driver circuit 100 of FIG. 1 and 2.

In FIG. 3, the control circuit 101 is illustrated by means of a voltage source V₁ that outputs a control signal (idealised high or zero). R_{LOAD} represents a small secondary load for the secondary side (which corresponds to the switch 102).

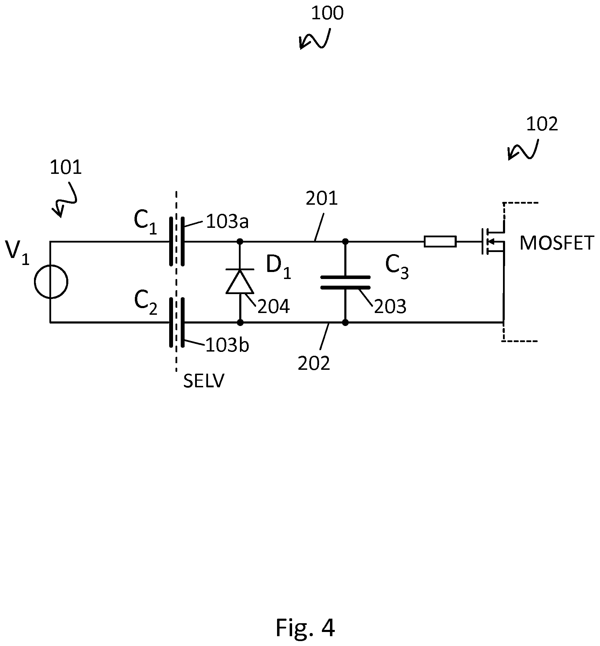

FIG. 4 shows an electrically isolated LED driver circuit 100 in more detail. The LED driver circuit 100 of FIG. 4 includes all functions and features of the LED driver circuit 100 of FIG. 1, 2 and 3.

In FIG. 4, the switch 102 is implemented by means of a MOSFET transistor.

In the following, the operating principle of the LED driver circuit 100 according to any one of FIG1. to FIG.4 is described.

The control circuit in particular operates in an ON-Phase and in an OFF-Phase.

ON-Phase: If the control circuit 101 outputs high, then current can flow over C₁ 103a, C₂ 103b and C₃ 203. Since these capacitors in particular can be small, they are charged fast. The voltage over capacitor C₃ 203 can then be used to control/drive different kinds of switches 102 (e.g. semiconductor switches) or also some other logic.

OFF-Phase: To put a low signal on to C₃ 203 the control circuit 101 outputs a low level signal, so that the primary sides of C₁ 103a and C₂ 103b are connected. Through this, the caps C₁ 103a, C₂ 103b and C₃ 203 get discharged.

In particular, the diode Di 204 can shift the voltage on C₃ 203, so that it lays between 0 and high. If this D₁ 204 is not implemented, positive and negative voltages would occur between C₃ 203.

Since all the control energy is stored into the capacitor C₃ 203, in a specific embodiment it is useful to control logic or switches 102 that need small power to control and or a small time to control, since during ON-Phase the capacitor C₃ 203 gets charged. During OFF-Phase the capacitor C₃ 203 gets discharged

The shown capacitor C₃ 203 could also be realised through the intrinsic-/parasitic-capacity of a semiconductor switch or logic.

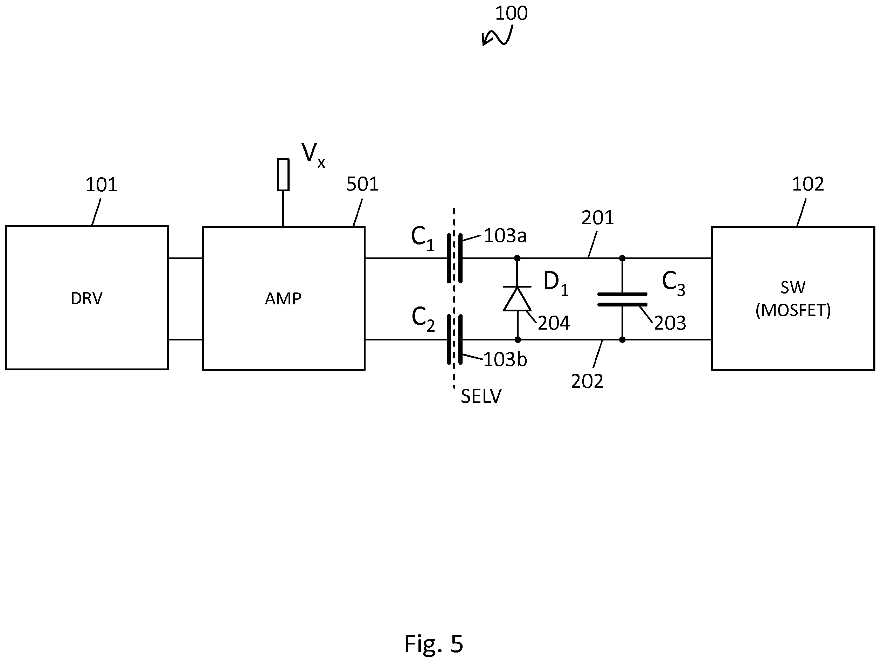

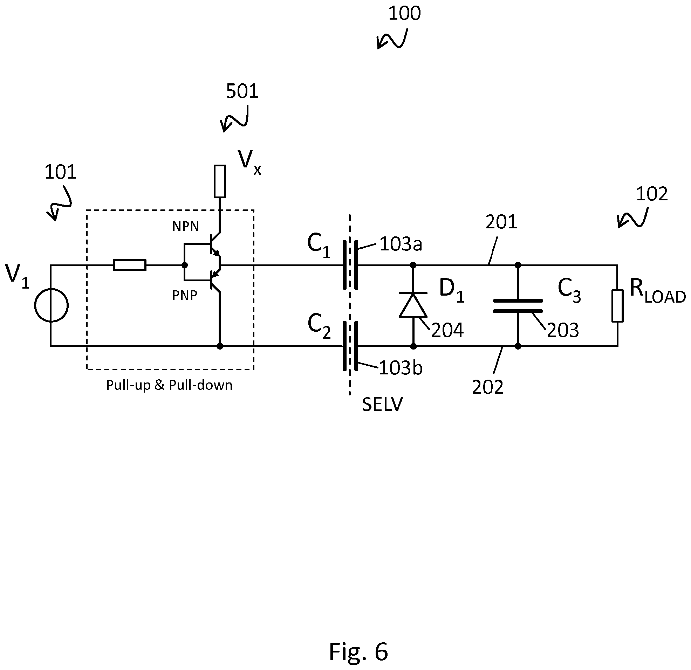

FIG. 5 and FIG. 6 show an electrically isolated LED driver circuit 100 in more detail, each. The LED driver circuits 100 of FIG. 5 and FIG. 6 include all functions and features of the LED driver circuit 100 of FIG. 1, 2, 3 and 4.

As it is illustrated in FIG. 5 and FIG. 6, in case that the controlled switch 102 or logic needs a higher voltage, the control circuit 101 can be amplified by an amplifying circuit 501 on the primary side to match these requirements.

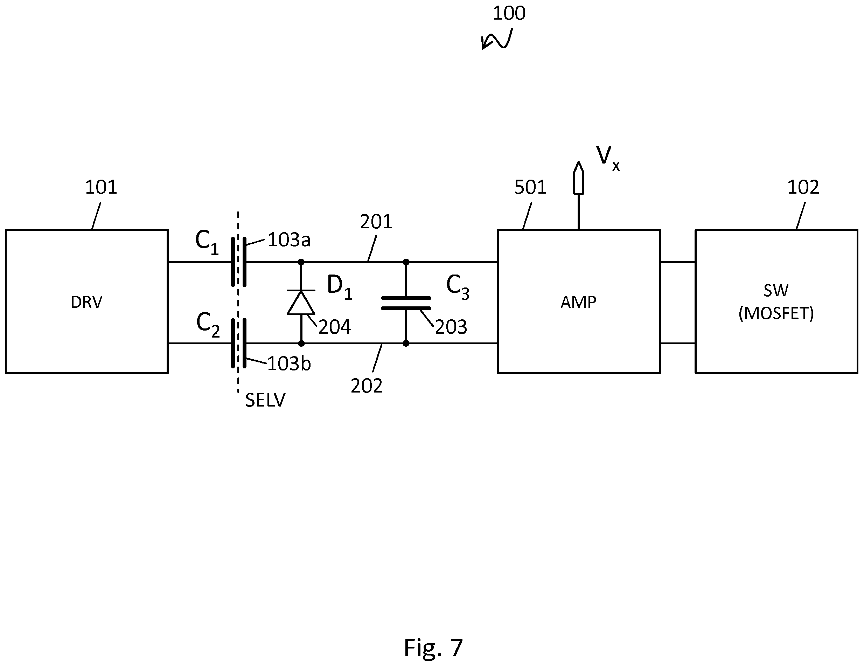

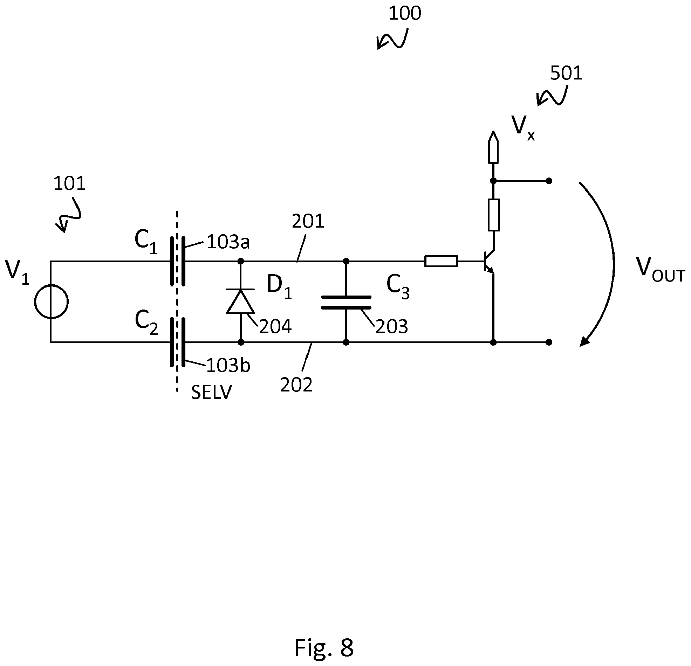

FIG. 7 and FIG. 8 show electrically isolated LED driver circuits 100 according to an embodiment of the present invention in more detail, each. The LED driver circuits 100 of FIG. 7 and FIG. 8 include all functions and features of the LED driver circuit 100 of FIG. 1, 2, 3 and 4.

As it is illustrated in FIG. 7 and FIG. 8, in case that the controlled switch 102 or logic needs a higher voltage, then the control circuit 101 can be amplified by an amplifying circuit 501 on the secondary side to match the requirements.

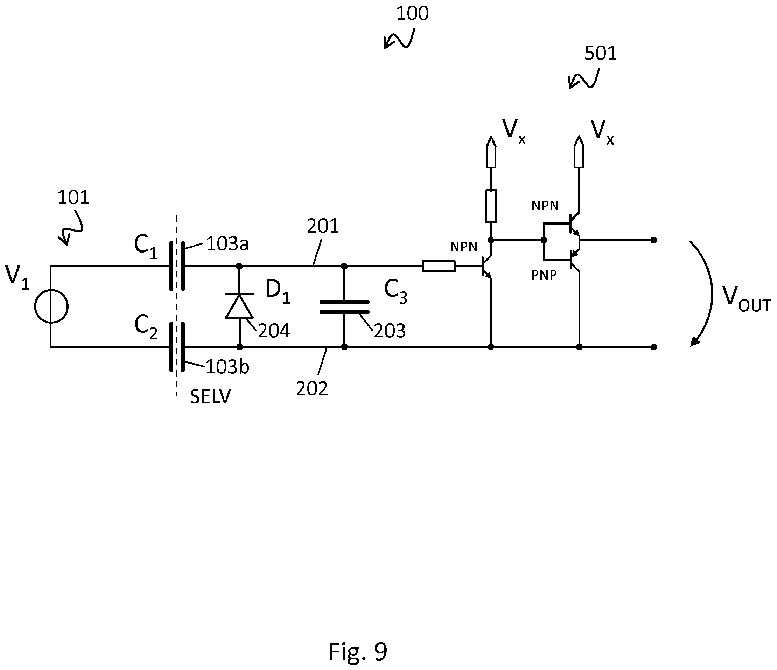

FIG. 9 shows an electrically isolated LED driver circuit 100 according to an embodiment of the present invention in more detail, each. The LED driver circuit 100 of FIG. 9 includes all functions and features of the LED driver circuit 100 of FIG. 1, 2, 3, 4, 7 and 8.

As shown in FIG. 9, another sub variation of the LED driver circuit 100 is that the switch 102 needs a higher amount of energy in order be controlled by the primary side. Instead of increasing the capacitors, an amplifier network is used to reduce the capacitor load over C₃ 203 (secondary capacitor).

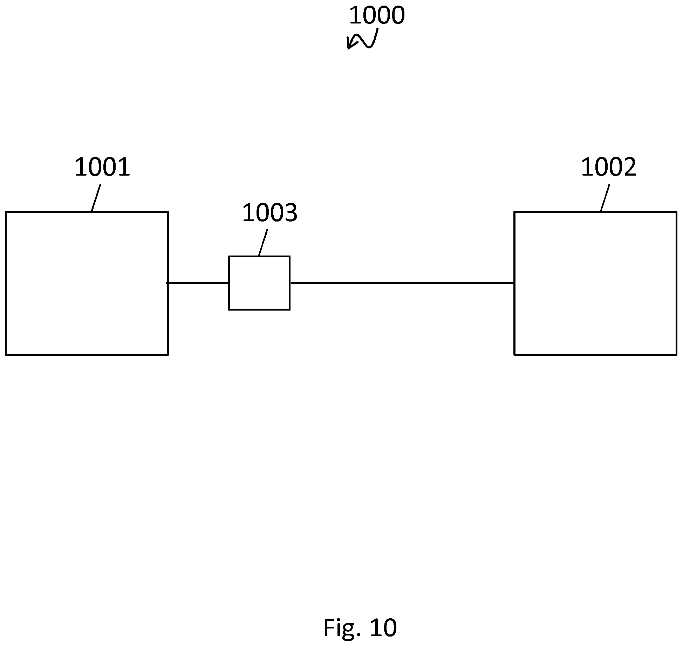

FIG. 10 shows an LED driver circuit 1000 according to an embodiment not covered by the present invention.

The LED driver circuit 1000 shown in FIG. 10 comprises a control circuit 1001, a switch 1002, and a capacitive element 1003. The control circuit 1001 operates the switch 1002 in a cycled manner. That is, the control circuit outputs a pulsed or clocked signal to control the switch 1002.

To protect the switch 1002, the capacitive element 1003 is configured to decouple an output of the control circuit 1001 from an input of the switch 1002.

That is, the LED driver circuit 1000 and the LED driver circuit 100 are two alternative solutions to a particular problem, i.e. how to provide a cheap and effective protection of the switch 1002, respectively the switch 102.

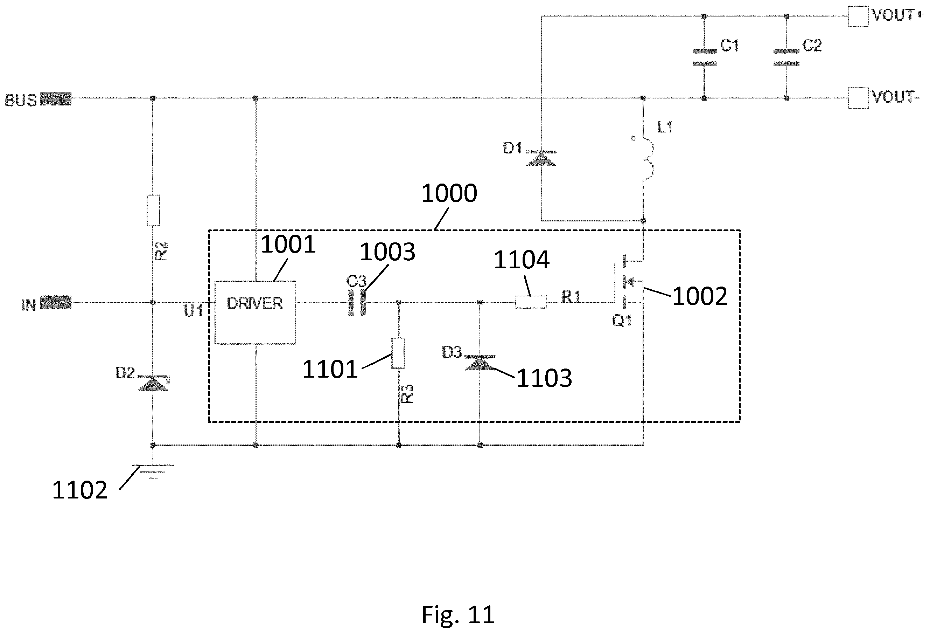

FIG. 11 shows an LED driver circuit 1000 according to an embodiment not covered by the present

invention in more detail. The LED driver circuit 1000 of FIG. 11 includes all functions and features of the LED driver circuit 1000 of FIG. 10.

The circuit of FIG. 11 would turn the switch 1002 (e.g. a MOSFET) off in the scenario presented in the background section (i.e. in case that the control circuit 1001 fails and constantly outputs a high signal). It can't protect against the failure of the switch 1002 (e.g. a MOSFET) itself, but it can protect against the failure of every other component that could interfere with the switch Q₁ 1002, as for example the protection Zener D2 in the circuit shown in FIG. 11. This diode does not have any active role in normal conditions, but in case of its failure, the whole device can be compromised and fails the standards.

The circuit shown in FIG. 11 can also be regarded as a high pass filter with a diode to reference the voltage to ground (C3 1003, D3 1103 and R3 1101 in FIG. 11). In a case in which R3 already exists in a circuit as a pull-down resistor of a MOSFET gate, it accumulates both functions, i.e. pull-down and high pass filter resistor.

As a high pass filter, this circuit will reject very low frequency or DC signal at the MOSFET gate. So if any component fails and causes the gate signal to be always high, the output of the high pass filter will be 0V turning off the MOSFET. In normal operation, it has no influence on the design. The capacitor offers no impedance to the gate. The value of the capacitor can be tuned to determine the reaction time and the cut-off frequency.

That is, as shown in FIG. 11, the LED driver circuit 1000 further can comprise a resistor 1101 connected to the capacitive element 1003 and to a ground potential 1102.

Specifically, as shown in FIG. 11, the LED driver circuit 1000 further can comprise a semiconductor element 1102 connected to the capacitive element 1003 and to a ground potential (1102).

Further optionally, the LED driver circuit 1000 can comprise a second resistor 1104 connected to the capacitive element 1003 and to the switch 1002, thereby indirectly connecting the capacitive element to the switch 1002.

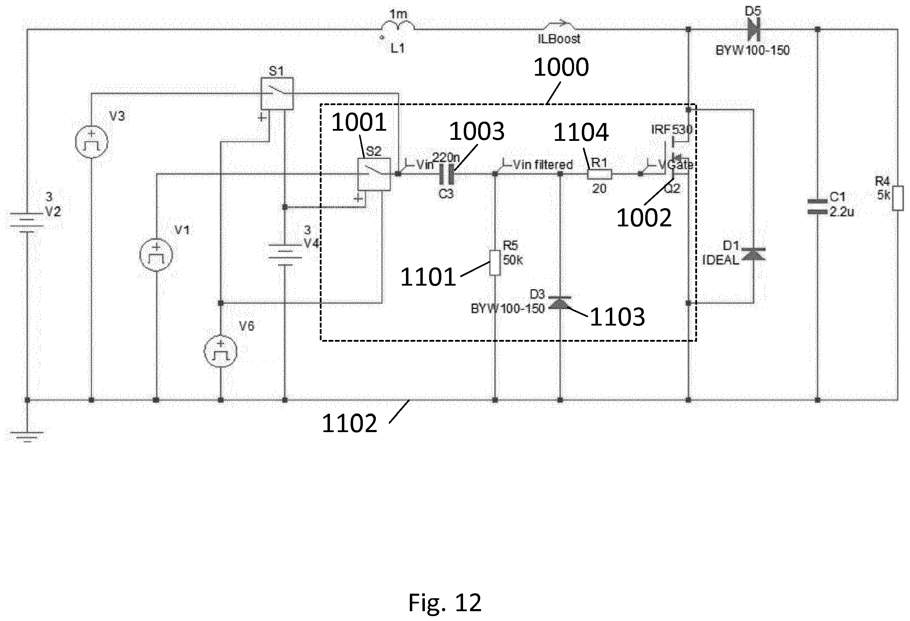

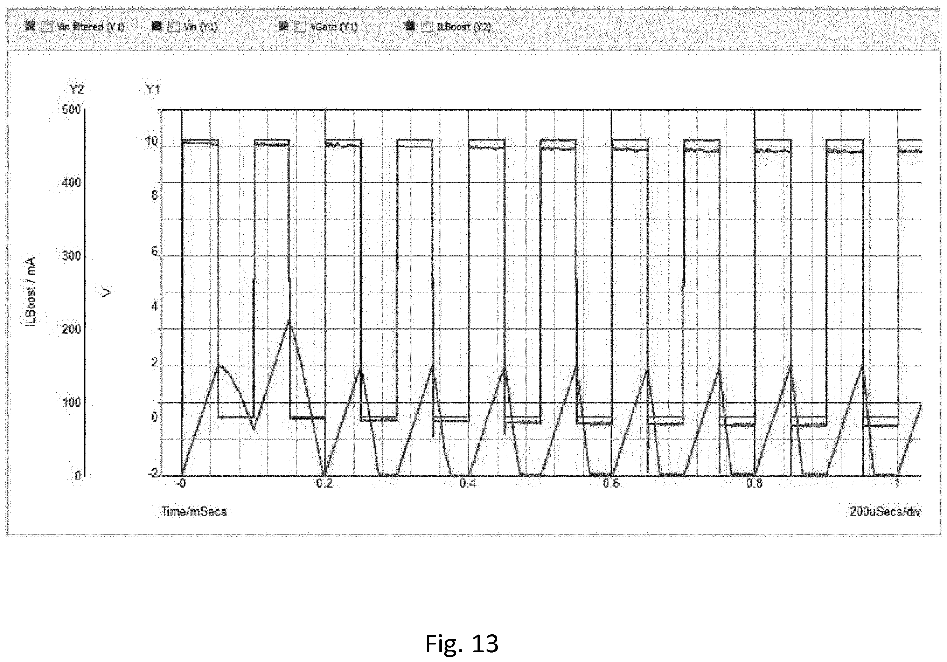

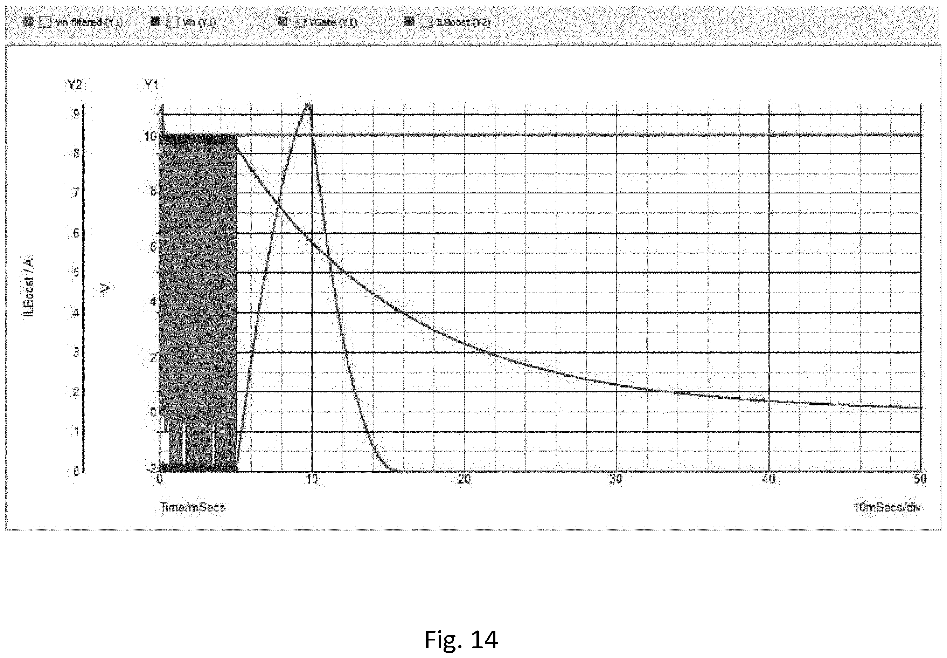

FIG. 12 shows the circuit of FIG. 11 being implemented in a converter. FIG. 12 in particular shows a boost converter with a gate protection circuit. FIG. 13 and FIG. 14 show simulation results of the circuit behavior of the converter of FIG. 12.

In FIG. 14, the gate switching signal is turned into a DC signal after 5ms. As a result, the high pass filter output rises as the input rises and then slowly reduces until 0V. Meanwhile, the current has a spike as the high pass filter capacitor charges. As the voltage in the output of the filter reduces, the current also reduces until 0A. Value of the peak current and how long it takes to go to 0A depends on the circuit itself and the size of the high pass filter capacitor. Smaller capacitors charge quicker so are turned off also quicker. On the other hand side, smaller capacitors also have higher cut-off frequency so this results in a compromise that needs to be reached in each design.

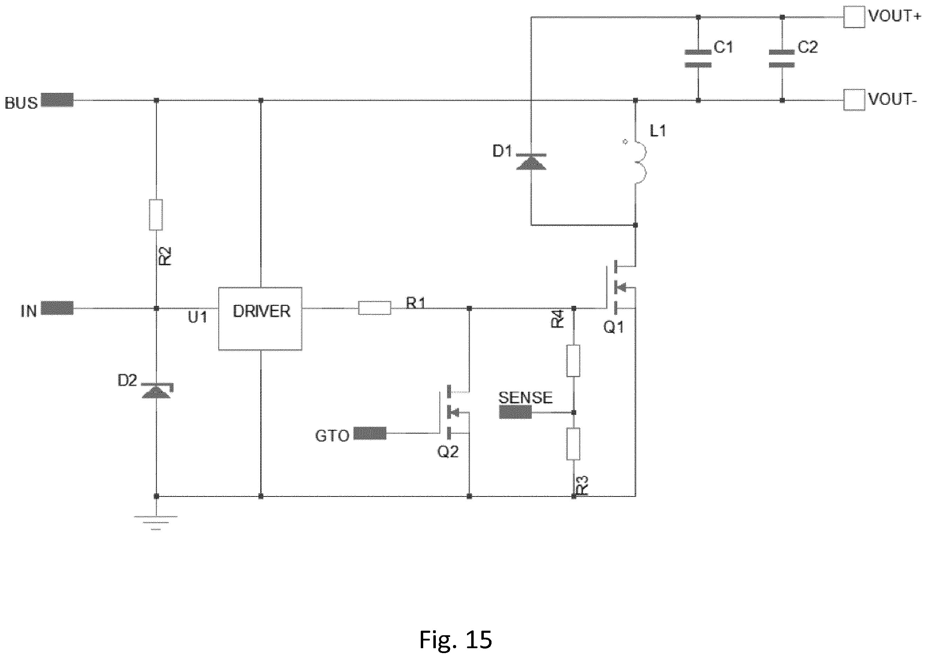

FIG. 15 shows a schematic view of an alternative LED driver circuit according to an embodiment not covered by the present invention in detail. FIG. 15 in particular shows a more direct way to directly measure the timing of the voltage at the gate and to use a switch, to ground and to turn off the main MOSFET, if the time exceeds an expected threshold.

This approach has the inconvenience of requiring measurement and an additional switch to be implemented, plus it requires a microcontroller. Meaning that if the microcontroller is the origin of the failure, this is not a reliable means to provide an alternative solution. Additionally, the sensing voltage depends on the voltage at the gate. If the gate is supplied from the main bus and the main bus collapses, as discussed before, the sensing is not reliable either. Additionally, the main MOSFET (Q1 in FIG. 15) is not shorting the BUS to ground, but the second MOSFET (Q2 in FIG. 15) will.

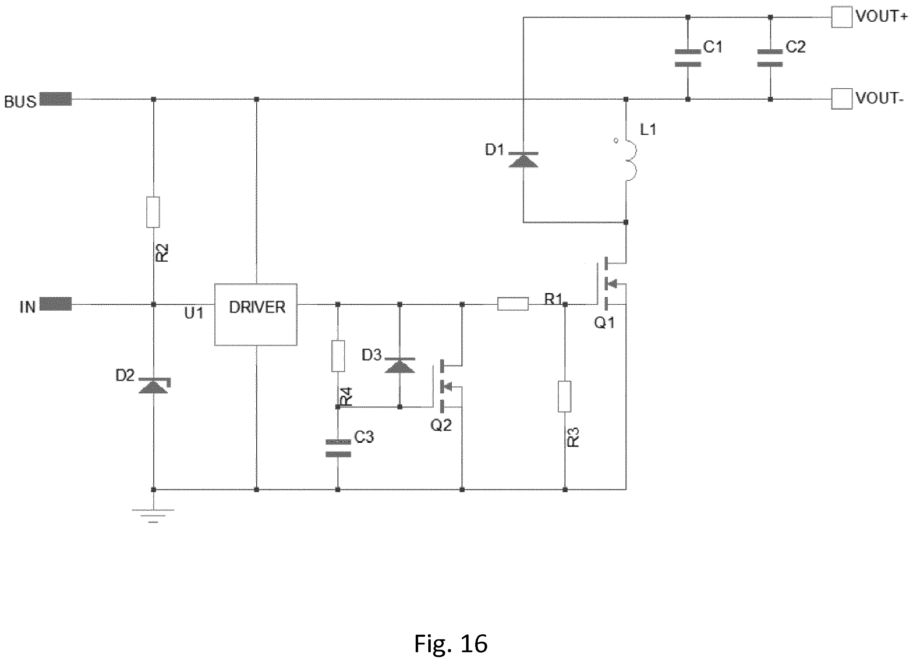

FIG. 16 shows a schematic view of an alternative LED driver circuit according to an embodiment not covered by the present invention in detail. FIG. 16 in particular shows an alternative way to use an RC circuit to turn the gate off, avoiding the use of a microcontroller.

In the circuit of FIG. 16, as the output of driver U1 goes high, C3 starts to charge through R4. In normal conditions, the output of U1 will return to LOW and C3 will discharge through D3 to ground via U1 output. C3 and R4 must be dimensioned to avoid Q2 to turn ON in normal operating conditions. If U1 output maintains HIGH, C3 will charge to the point that Q2 will turn ON. The bus voltage may stabilize at Q2 gate threshold.

Both alternatives shown in FIG. 15 and FIG. 16 may turn the main MOSFET off but will still short the main BUS to ground via the driver U1. Alternatively, instead of a MOSFET to ground, a MOSFET in line with the gate might be used, as shown in FIG: 17.

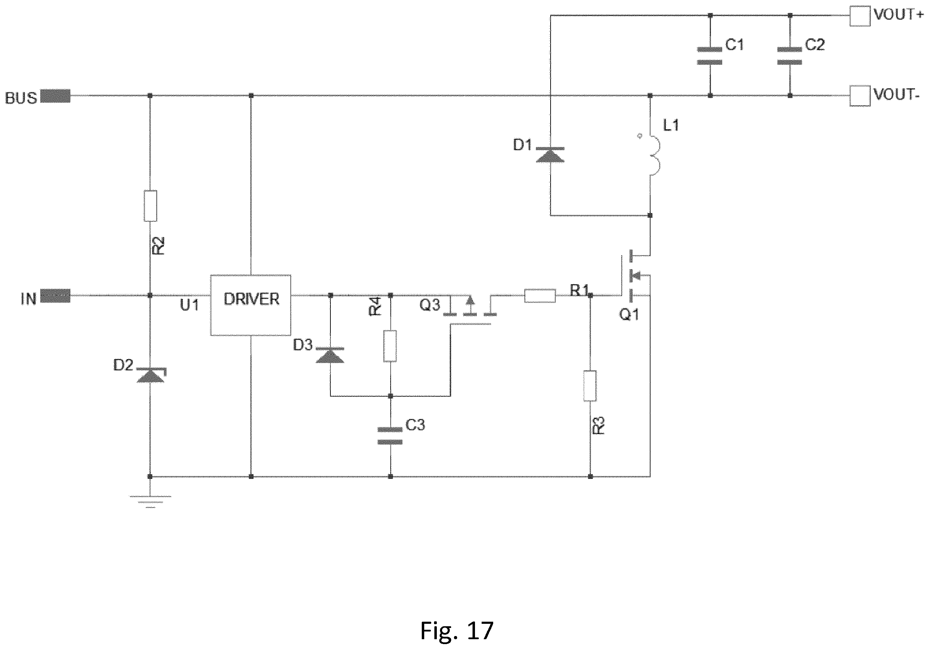

In this concept of FIG. 17, a capacitor charges every time when the driver U1 output goes high through R4. In normal conditions, the driver output should go low, discharging C3 through D3. This operation maintains the average voltage across C3 much lower than Q3 source. In case of a fault, C3 won't reset charging until the voltage matches Q3 source voltage, turning Q3 off. Q3 off will turn the main MOSFET Q1 off.

This alternative is based on the same principal of a high pass filter circuit, using a capacitor to filter the gate signal voltage, and based on the result, turn on or off the switch in line with the main MOSFET gate.

This is an advantageous switch based concept. It is not dependent on voltage level (although the voltage must be high enough to trigger the P-channel gate); the switch is in line so the bus won't be shorted to ground via driver U1; and it doesn't need a control signal.

When simulating this circuit, its behavior is very satisfying and close to the one obtained with the high pass filter above. In the following, the simulation of the same circuit used to simulate the high pass filter concept behavior is discussed.

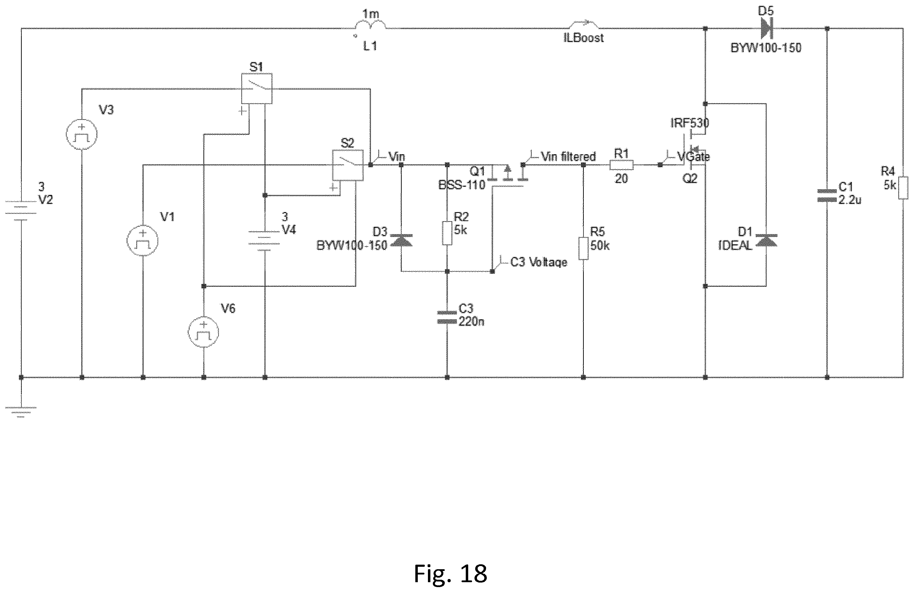

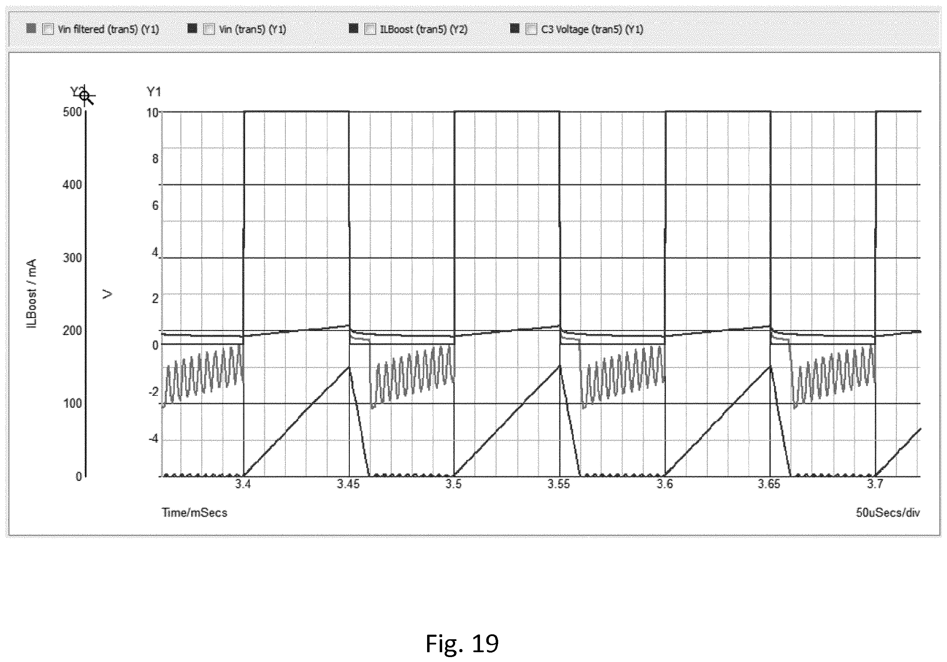

FIG. 18 shows the circuit of FIG. 17 being implemented in a converter. FIG. 18 in particular shows a boost converter with a gate protection circuit. FIG. 19, FIG. 20, FIG. 21 and FIG. 22 show simulation results of the circuit behavior of the converter of FIG. 18.

The waveforms obtained are shown in FIG. 19.

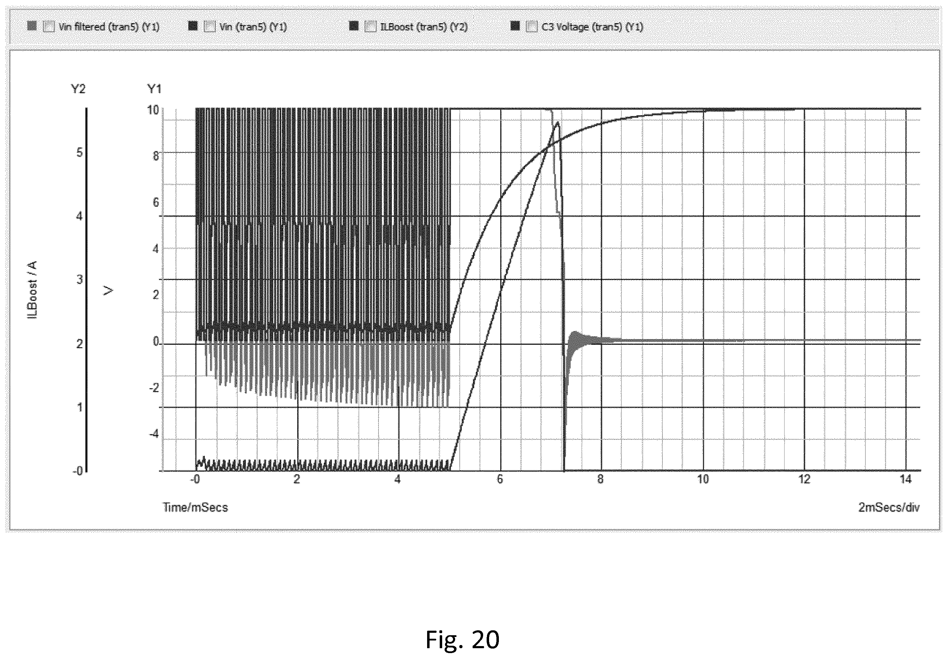

In a larger time scale, the protection circuit can be seen acting in FIG. 20 when the gate driver output turns into a DC constant voltage. In FIG. 20, it is possible to see that as the gate signal turns into a constant DC signal, C3 starts to rise, and the current in the main MOSFET, too. When C3 voltage reaches the gate drive voltage, Q1 is turned OFF and the voltage in the main MOSFET gate goes to 0V and the current drops quickly to 0A.

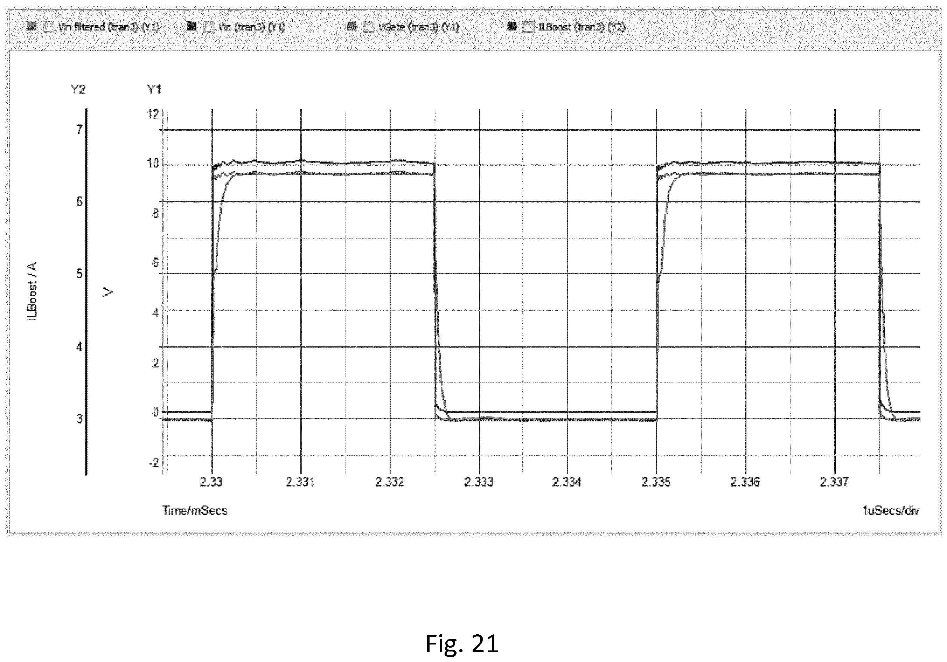

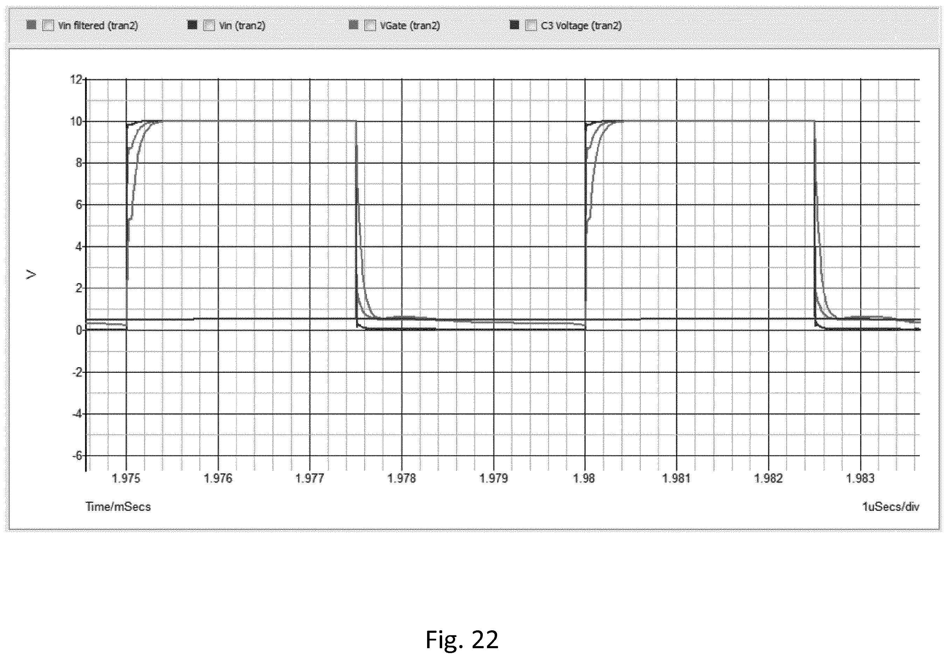

As shown in FIG. 21 and FIG. 22, another known issue is that at very high frequencies, greater than 100kHz, the signal after the protection circuit starts to get distorted. Cf. plots in FIG. 21 and FIG. 22 comparing this circuit with the initial proposed high pass filter, for 200kHz switching. In these figures it can be seen that in the plot representing the output of the protection circuits, the edges of the waveform are trimmed for the active switch circuit. The signal at the main MOSFET gate also looks more filtered as consequence.

According to this embodiment not covered by the present invention in view of FIG. 10 to 22, a passive circuit is provided to turn a switch (e.g. a switching MOSFET) off, based on the nature of the gate drive signal, preventing the MOSFET to stay on in case of a fault in the gate control. The circuit is based in a high pass filter, that will reject any DC signal that can appear in the gate in case of fault. The circuit, is simple, effective, cheap and doesn't interfere with normal operation of a switch, e.g. a MOSFET. Alternatively, active circuits can be used to achieve similar effects.

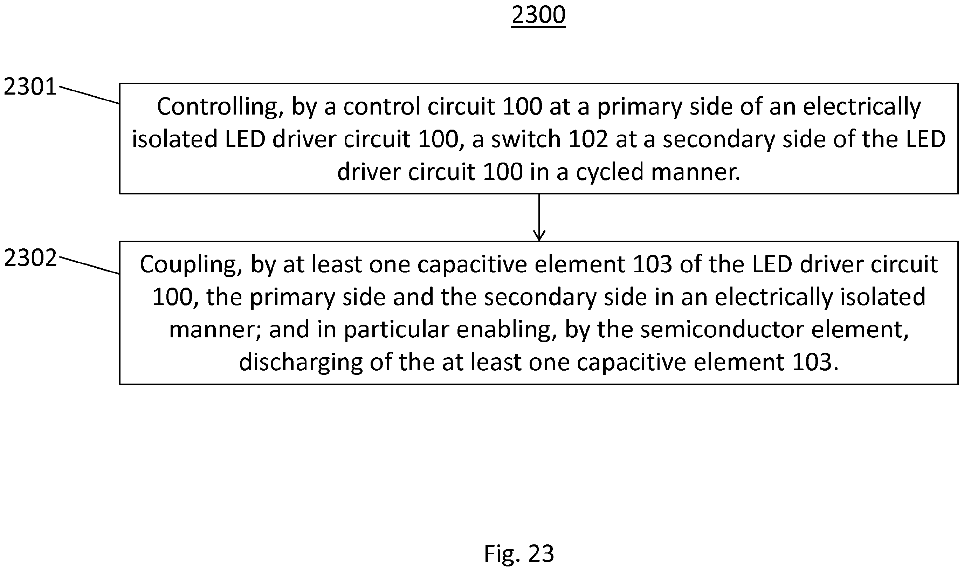

FIG. 23 shows a schematic view of a method 2300 which is for operating an electrically isolated LED driver circuit 100, wherein the LED driver circuit comprises a control circuit 101 at a primary side of the LED driver circuit 100, a switch 102 at a secondary side of the LED driver circuit 100, a semiconductor element and at least one capacitive element 103. The method 2300 comprises a step of controlling 2301, by the control circuit 100, the switch 102 in a cycled manner. The method also comprises a step of coupling 2302, by the at least one capacitive element 103, the primary side and the secondary side in an electrically isolated manner and in particular enabling, by the semiconductor element, discharging of the at least one capacitive element.

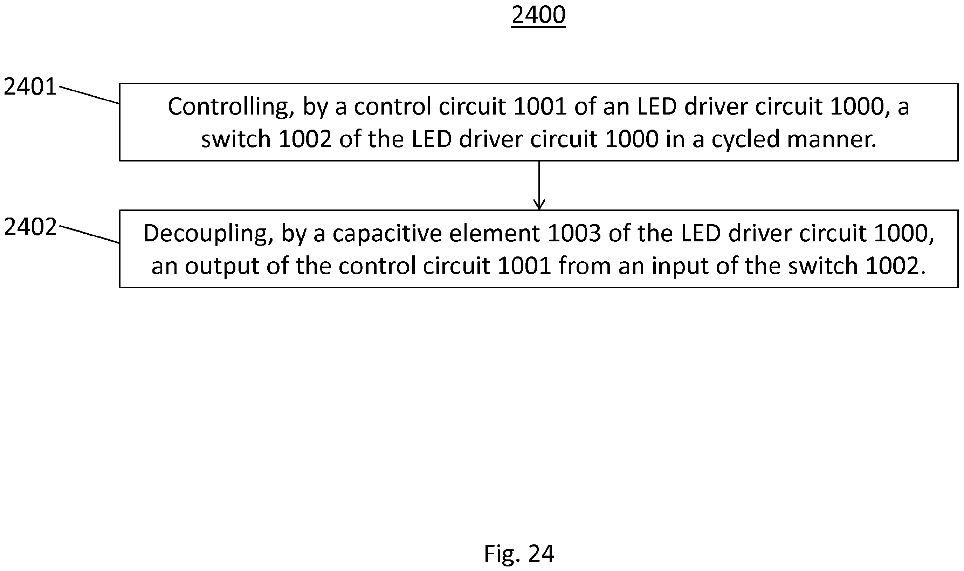

FIG. 24 shows a schematic view of a method 2400 which is for operating an LED driver circuit 1000, wherein the LED driver circuit 1000 comprises a control circuit 1001, a switch 1002, and a capacitive element 1003. The method 2400 comprises a step of controlling 2401, by the control circuit 1001, the switch 1002 in a cycled manner. The method 2400 also comprises a step of decoupling 2402, by the capacitive element 1003, an output of the control circuit 1001 from an input of the switch 1002.

## Claims

1. An electrically isolated LED driver circuit (100), comprising:
- a control circuit (101) at a primary side of the LED driver circuit (100),
- a switch (102) at a secondary side of the LED driver circuit (100),
- a semiconductor element, and
- at least one capacitive element (103);
wherein the control circuit (101) is configured to control the switch (102) in a cycled manner;
wherein the at least one capacitive element (103) is configured to couple the primary side and the secondary side in an electrically isolated manner; and
wherein the semiconductor element is configured to enable discharging of the at least one capacitive element (103), wherein the control circuit (101) is configured to output a control signal to control the switch (102), and wherein the LED driver circuit (100) further comprises an amplifying circuit (501) on the secondary side configured to amplify the control signal.

2. The LED driver circuit (100) according to claim 1, wherein the at least one capacitive element (103) is a capacitor.

3. The LED driver circuit (100) according to claim 1 or 2, wherein the at least one capacitive element (103) is a Y-capacitor, preferably a Y1-capacitor or a Y2-capacitor.

4. The LED driver circuit (100) according to any of the preceding claims, wherein the at least one capacitive element (103) includes a first capacitive element (103a) and a second capacitive element (103b), wherein the first capacitive element (103a) and the second capacitive element (103b) are configured to couple the primary-side and the secondary-side in an electrically isolated manner.

5. The LED driver circuit (100) according to any of the preceding claims, wherein the first capacitive element (103a) is arranged in a first path (201) of the LED driver circuit (100), and the second capacitive element (103b) is arranged in a second path (202) of the LED driver circuit (100).

6. The LED driver circuit (100) according to any of the preceding claims, wherein the LED driver circuit (100) further comprises a third capacitive element (203), configured to couple the first path (201) and the second path (202).

7. The LED driver circuit (100) according to any of the preceding claims, wherein the semiconductor element (204) is connected to the first path (201), and to the second path (202).

8. The LED driver circuit (100) according to any of the preceding claims, wherein the semiconductor element (204) is configured to control a voltage through the third capacitive element (203).

9. The LED driver circuit (100) according to any of the preceding claims, wherein the control circuit (101) is configured to control the switch by means of a Boolean signal.

10. A method (2300) for operating an electrically isolated LED driver circuit (100), wherein the LED driver circuit (100) comprises a control circuit (101) at a primary side of the LED driver circuit (100), a switch (102) at a secondary side of the LED driver circuit (100), a semiconductor element, and at least one capacitive element (103); the method (2300) comprising the steps of
- controlling (2301), by the control circuit (100), the switch (102) in a cycled manner; and
- coupling (2302), by the at least one capacitive element (103), the primary side and the secondary side in an electrically isolated manner; and in particular enabling, by the semiconductor element, discharging of the at least one capacitive element (103),
- output a control signal to control the switch (102), and
- amplify the control signal by an amplifying circuit (501) on the secondary side of the LED driver circuit (100).

## Patentansprüche

1. Elektrisch isolierte LED-Treiberschaltung (100), umfassend:
- eine Steuerschaltung (101) auf einer Primärseite der LED-Treiberschaltung (100),
- einen Schalter (102) auf einer Sekundärseite der LED-Treiberschaltung (100),
- ein Halbleiterelement, und
- mindestens ein kapazitives Element (103);
wobei die Steuerschaltung (101) konfiguriert ist, um den Schalter (102) in einer getakteten Weise zu steuern;
wobei das mindestens eine kapazitive Element (103) konfiguriert ist, um die Primärseite und die Sekundärseite in einer elektrisch isolierten Weise zu koppeln; und
wobei das Halbleiterelement konfiguriert ist, um das Entladen des mindestens einen kapazitiven Elements (103) zu ermöglichen, wobei die Steuerschaltung (101) konfiguriert ist, um ein Steuersignal auszugeben, um den Schalter (102) zu steuern, und wobei die LED-Treiberschaltung (100) ferner eine Verstärkerschaltung (501) auf der Sekundärseite umfasst, die konfiguriert ist, um das Steuersignal zu verstärken.

2. LED-Treiberschaltung (100) nach Anspruch 1, wobei das mindestens eine kapazitive Element (103) ein Kondensator ist.

3. LED-Treiberschaltung (100) nach Anspruch 1 oder 2, wobei das mindestens eine kapazitive Element (103) ein Y-Kondensator ist, vorzugsweise ein Y1-Kondensator oder ein Y2- Kondensator.

4. LED-Treiberschaltung (100) nach einem der vorstehenden Ansprüche, wobei das mindestens eine kapazitive Element (103) ein erstes kapazitives Element (103a) und ein zweites kapazitives Element (103b) einschließt, wobei das erste kapazitive Element (103a) und das zweite kapazitive Element (103b) konfiguriert sind, um die Primärseite und die Sekundärseite elektrisch isoliert zu koppeln.

5. LED-Treiberschaltung (100) nach einem der vorstehenden Ansprüche, wobei das erste kapazitive Element (103a) in einem ersten Pfad (201) der LED-Treiberschaltung (100) angeordnet ist und das zweite kapazitive Element (103b) in einem zweiten Pfad (202) der LED-Treiberschaltung (100) angeordnet ist.

6. LED-Treiberschaltung (100) nach einem der vorstehenden Ansprüche, wobei die LED-Treiberschaltung (100) ferner ein drittes kapazitives Element (203) umfasst, das konfiguriert ist, um den ersten Pfad (201) und den zweiten Pfad (202) zu koppeln.

7. LED-Treiberschaltung (100) nach einem der vorstehenden Ansprüche, wobei das Halbleiterelement (204) mit dem ersten Pfad (201) und mit dem zweiten Pfad (202) verbunden ist.

8. LED-Treiberschaltung (100) nach einem der vorstehenden Ansprüche, wobei das Halbleiterelement (204) konfiguriert ist, um eine Spannung durch das dritte kapazitive Element (203) zu steuern.

9. LED-Treiberschaltung (100) nach einem der vorstehenden Ansprüche, wobei die Steuerschaltung (101) konfiguriert ist, um den Schalter mittels eines booleschen Signals zu steuern.

10. Verfahren (2300) zum Betreiben einer elektrisch isolierten LED-Treiberschaltung (100), wobei die LED-Treiberschaltung (100) eine Steuerschaltung (101) auf einer Primärseite der LED-Treiberschaltung (100), einen Schalter (102) auf einer Sekundärseite der LED-Treiberschaltung (100), ein Halbleiterelement und mindestens ein kapazitives Element (103) umfasst; wobei das Verfahren (2300) die folgenden Schritte umfasst
- Steuern (2301), durch die Steuerschaltung (100), des Schalters (102) in einer getakteten Weise; und
- Koppeln (2302), durch das mindestens eine kapazitive Element (103), der Primärseite und der Sekundärseite in einer elektrisch isolierten Weise; und insbesondere Ermöglichen, durch das Halbleiterelement, des Entladens des mindestens einen kapazitiven Elements (103),
- Ausgeben eines Steuersignals, um den Schalter (102) zu steuern, und
- Verstärken des Steuersignals durch eine Verstärkungsschaltung (501) auf der Sekundärseite der LED-Treiberschaltung (100).

## Revendications

1. Circuit d'attaque de DEL électriquement isolé (100), comprenant :
- un circuit de commande (101) au niveau d'un côté primaire du circuit d'attaque de DEL (100),
- un commutateur (102) au niveau d'un côté secondaire du circuit d'attaque de DEL (100),
- un élément semi-conducteur, et
- au moins un élément capacitif (103) ;
dans lequel le circuit de commande (101) est configuré pour commander le commutateur (102) de manière cyclique ;
l'au moins un élément capacitif (103) étant configuré pour coupler le côté primaire et le côté secondaire d'une manière électriquement isolée ; et
l'élément semi-conducteur étant configuré pour permettre la décharge de l'au moins un élément capacitif (103), le circuit de commande (101) étant configuré pour délivrer un signal de commande pour commander le commutateur (102), et le circuit d'attaque de DEL (100) comprenant en outre un circuit d'amplification (501) sur le côté secondaire configuré pour amplifier le signal de commande.

2. Circuit de commande de DEL (100) selon la revendication 1, dans lequel l'au moins un élément capacitif (103) est un condensateur.

3. Circuit de commande de DEL (100) selon la revendication 1 ou 2, dans lequel l'au moins un élément capacitif (103) est un condensateur Y, de préférence un condensateur Y1 ou un condensateur Y2.

4. Circuit de commande de DEL (100) selon l'une quelconque des revendications précédentes, dans lequel l'au moins un élément capacitif (103) comporte un premier élément capacitif (103a) et un second élément capacitif (103b), dans lequel le premier élément capacitif (103a) et le deuxième élément capacitif (103b) sont configurés pour coupler le côté primaire et le côté secondaire d'une manière isolée électriquement.

5. Circuit d'attaque de DEL (100) selon l'une quelconque des revendications précédentes, dans lequel le premier élément capacitif (103a) est agencé dans un premier trajet (201) du circuit d'attaque de DEL (100), et le deuxième élément capacitif (103 b) est agencé dans un second trajet (202) du circuit d'attaque de DEL (100).

6. Circuit d'attaque de DEL (100) selon l'une quelconque des revendications précédentes, dans lequel le circuit d'attaque de DEL (100) comprend en outre un troisième élément capacitif (203), configuré pour coupler le premier trajet (201) et le second trajet (202).

7. Circuit d'attaque de DEL (100) selon l'une quelconque des revendications précédentes, dans lequel l'élément semi-conducteur (204) est connecté au premier trajet (201) et au second trajet (202).

8. Circuit de commande de DEL (100) selon l'une quelconque des revendications précédentes, dans lequel l'élément semi-conducteur (204) est configuré pour commander une tension à travers le troisième élément capacitif (203).

9. Circuit de commande de DEL (100) selon l'une quelconque des revendications précédentes, dans lequel le circuit de commande (101) est configuré pour commander le commutateur au moyen d'un signal booléen.

10. Procédé (2300) pour faire fonctionner un circuit d'attaque de DEL électriquement isolé (100), dans lequel le circuit d'attaque de DEL (100) comprend un circuit de commande (101) au niveau d'un côté primaire du circuit d'attaque de DEL (100), un commutateur (102) au niveau d'un côté secondaire du circuit d'attaque de DEL( 100), un élément semi-conducteur et au moins un élément capacitif (103) ; le procédé (2300) comprenant en outre les étapes consistant à
- commander (2301), par le circuit de commande (100), le commutateur (102) de manière cyclique ; et
- coupler (2302), par l'au moins un élément capacitif (103), du côté primaire et du côté secondaire de manière électriquement isolée ; et en particulier permettant, par l'élément semi-conducteur, de décharger l'au moins un élément capacitif (103),
- délivrer en sortie un signal de commande pour commander le commutateur (102), et
- amplifier le signal de commande par un circuit d'amplification (501) sur le côté secondaire du circuit de commande de DEL (100).
